## Europäisches Patentamt

## European Patent Office

## Office européen des brevets

(19)

(11) Veröffentlichungsnummer: **0 054 737**
**B1**

(12) **EUROPÄISCHE PATENTSCHRIFT**

(45) Veröffentlichungstag der Patentschrift:
**23.04.86**

(51) Int. Cl.⁴: **H 01 L 31/06, H 01 L 31/02**

(21) Anmeldenummer: **81109453.1**

(22) Anmeldetag: **31.10.81**

(54) Halbleiterbauelement für die Umsetzung von Licht in elektrische Energie.

(30) Priorität: **22.12.80 DE 3048381**

(43) Veröffentlichungstag der Anmeldung:
**30.06.82 Patentblatt 82/26**

(45) Bekanntmachung des Hinweises auf die Patenterteilung:
**23.04.86 Patentblatt 86/17**

(84) Benannte Vertragsstaaten:
**AT BE CH FR GB IT LI NL**

(56) Entgegenhaltungen:
**EP - A - 0 025 872**
**DD - A - 140 945**
**DE - A - 2 701 284**
**DE - A - 2 812 547**
**US - A - 4 166 919**

(73) Patentinhaber: **Messerschmitt-Bölkow-Blohm Gesellschaft mit beschränkter Haftung, Robert-Koch-Strasse, D-8012 Ottobrunn (DE)**

(72) Erfinder: **Winterling, Gerhard, Dr. Dipl.-Phys., Hermann-Löns-Strasse 16, D-8012 Ottobrunn (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

**Beschreibung**

Die Erfindung betrifft ein Halbleiterbauelement für die Umsetzung von Licht in elektrische Energie mit mindestens einer Schicht amorphen Siliziums, an die sich auf der Lichteinfallseite des Halbleiterbauelements eine Deckschicht aus polykristallinem Silizium anschliesst, wobei die Deckschicht zwischen einer Antireflexschicht aus halbleitendem transparentem Oxyd und der Schicht aus amorphem Silizium angeordnet ist, nach der gemäss Art. 54(3) EPÜ zum Stand der Technik zählenden europäischen Patentanmeldung EP-A-0025 872.

In der genannten Anmeldung ist beschrieben, wie mittels Verwendung einer Deckschicht aus polykristallinem Silizium auf der Halbleiterschicht aus amorphem Silizium die Blauausbeute von Solarzellen mit p–i–n-Struktur und damit der Wirkungsgrad wesentlich verbessert werden kann. In dieser Patentanmeldung wurde bereits darauf hingewiesen, dass eine dünne polykristalline Siliziumschicht bei einer a–Si-Zelle von Nutzen ist, um die Lichtabsorption in der hochdotierten Siliziumkontaktschicht auf der Lichteinfallseite weitgehend zu eliminieren.

Bei der Optimierung des Wirkungsgrades von Solarzellen ist es wichtig, neben einer Verbesserung des internen Sammelwirkungsgrades, d.h. der durch Lichtabsorption erzeugten elektrischen Ladungsträger, auch dafür Sorge zu tragen, dass das einfallende Licht möglichst ohne Reflexionsverluste in das aktive Zellmaterial eindringen kann.

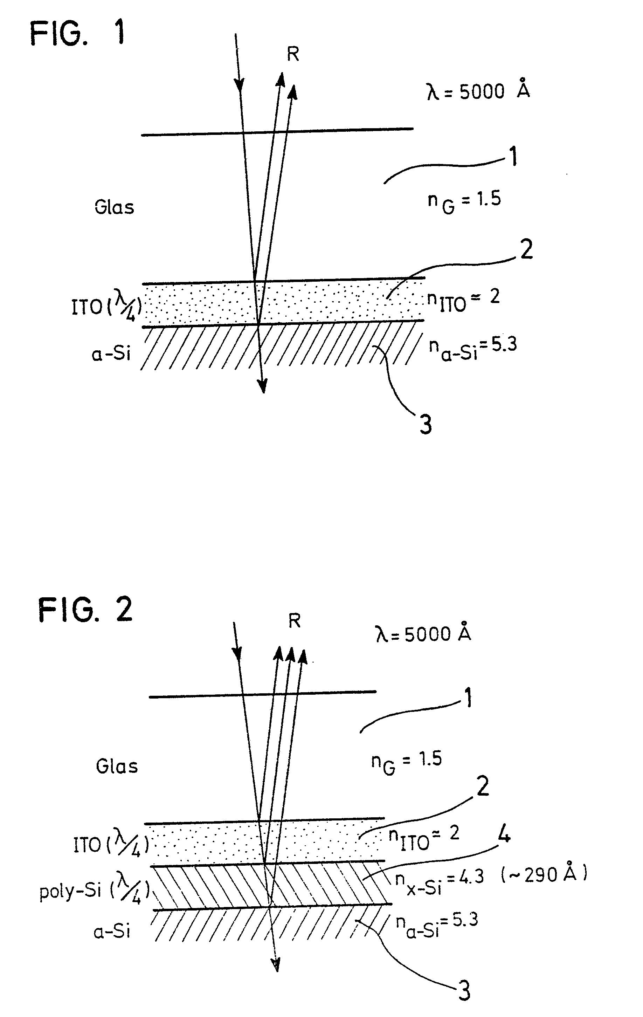

Die Reflexionsverluste werden nach dem Stand der Technik, siehe US-A-40 64 521 Spalte 3, Zeile 38 f, minimalisiert durch das Aufbringen von (transparenten) Antireflexschichten, siehe Fig. 1, in der mit 1 eine Abdeckplatte, mit 2 die Antireflexschicht und mit 3 die Schicht aus a–Si bezeichnet ist.

Die Antireflexschicht 2 hat im einfachsten Fall, wenn die Reflexionslöschung nur in einem begrenzten Spektralbereich und wirtschaftlich erfolgen soll, die optische Schichtdicke einer Viertel Wellenlänge ($\lambda/4$), wobei zur Auslöschung der Brechungsindex $n_{AR}$ der Antireflexschicht abhängt von den Brechungsindices der angrenzenden Medien 1, 2 entsprechend der Beziehung

$$n_{AR} = \sqrt{n_1 n_2}.$$

Für Halbleiterbauelemente aus kristallinem Si (mit $n_{x-si} \simeq 4$ bei 6000 Å) wird als Material für die Antireflexschicht SiO, TiO$_x$ (n = 2.3) und Ta$_2$O$_5$ (n = 2,05) und auch Zinnoxyd (n $\simeq$ 2) und Indiumzinnoxyd (n $\simeq$ 2) verwendet.

Bei Halbleiterbauelementen auf der Basis von amorphem Silizium (a–Si), die in letzter Zeit starkes Interesse wegen der Möglichkeit einer billigen Herstellung gefunden haben, wurde als Antireflexschicht meistens Indiumzinnoxyd (ITO) verwendet. ITO bietet ebenso wie SnO$_2$ hierbei den weiteren Vorteil, dass es bei den a–Si-Zellen durch seine hohe elektrische Leitfähigkeit (transparenter Halbleiter!) entscheidend dazu beiträgt, den elektrischen Schichtwiderstand auf der Lichteinfallseite herabzusetzen. Dadurch werden Elektrodenfingerstrukturen mit grösserem Fingerabstand möglich.

Während sich nun Indiumzinnoxyd wie auch Zinnoxyd für die Reflexionsminderung bei kristallinem Si gut eignen, bleibt bei Verwendung auf a–Si eine Restreflexion von etwa R = 10% im Grünen (siehe Fig. 1), da der Brechungsindex von a–Si mit n $\gtrsim$ 5 wesentlich höher ist als der von kristallinem Si. Zur Minimalisierung der Restreflexion auf a–Si wäre eine Antireflexschicht mit Brechungsindex

$$n_{AR} = \sqrt{n_{Glas} \times n_{a-Si}}$$

$\simeq$ 2,8 erforderlich, wofür beispielsweise TiO$_x$ mit x $\simeq$ 2 in Frage käme. TiO$_2$ und auch andere transparente Materialien mit vergleichbar hohem Brechungsindex haben aber nur noch eine kleine elektrische Leitfähigkeit und können deshalb nicht den erwünschten Beitrag zur Herabsetzung des Schichtwiderstandes bringen.

Aufgabe der vorliegenden Erfindung ist es, ein Halbleiterbauelement nach der gemäss Artikel 54(3) EPÜ zum Stand der Technik zählenden europäischen Patentanmeldung EP-A-0025 872 anzugeben, bei dem die Reflexionsverluste minimalisiert sind und der hohe Schichtwiderstand der a–Si-Schicht reduziert wird.

Diese Aufgabe ist dadurch gelöst, dass die Deckschicht die optische Dicke

$$\frac{\lambda \text{ Licht}}{4} \text{ oder } \frac{3\lambda \text{ Licht}}{4}$$

aufweist und die Antireflexschicht einen Brechungsindex < 2,8 besitzt.

Die Reflexionsverluste werden nahezu um den Faktor 7 vermindert. Die polykristalline Si-Schicht hat den weiteren Vorteil, dass die in ihr durch die Rest-Lichtabsorption erzeugten Ladungsträger im Gegensatz zur dotierten a–Si-Schicht die Chance haben, zum Photostrom und damit zu einer Verbesserung des Wirkungsgrades beizutragen.

Die Erfindung ist anhand der Fig. 2 näher erläutert. In dieser sind gleiche Elemente mit denselben Bezugszeichen versehen wie in Fig. 1.

Nach dem heutigen Stand der Technik kommen als Antireflexschicht 2 Oxyde wie ITO, SnO$_2$ oder Cd$_2$SnO$_4$ in Frage, die alle Brechungsindices bei etwa n $\simeq$ 2 haben.

Die Reflexionsverluste werden minimalisiert durch Zwischenschaltung einer Deckschicht 4 aus polykristallinem Si zwischen die Antireflexschicht 2 und die Schicht 3 aus a–Si; die optische Dicke der Deckschicht 4 beträgt $\lambda/4$ wie in der Fig. 2 an einem Beispiel mit ITO dargestellt. Die geometrische Dicke einer $\lambda/4$ polykristallinen Si-Schicht liegt bei

$$d = \frac{\lambda \text{ Licht}}{4n} \simeq 290 \text{ A}°,$$

wenn die Reflexionsauslöschung schwerpunkt-

mässig bei der Licht-Wellenlänge 5000 A gewählt wird.

Der Reflexionsverlust lässt sich leicht durch Einsetzen in die folgende Formel errechnen:

$$R = \left[ \frac{n_{ITO} - n_G}{n_{ITO} + n_G} - \frac{n_{x-Si} - n_{ITO}}{n_{x-Si} + n_{ITO}} + \frac{n_{x-Si} - n_{a-Si}}{n_{xSi} + n_{a-Si}} \right]^2$$

mit  R  =  Reflexionsverlust

$n_i$  =  Brechungsindices

Der Reflexionsverlust ergibt sich mit $R \simeq 1{,}4\%$ und ist damit erheblich geringer als $R = 9{,}5\%$ ohne den Einsatz der Erfindung (siehe Fig, 1), d. h., wenn in herkömmlicher Weise, d. h. ohne zusätzliche polykristalline Si-Schicht, verfahren wird.

## Patentanspruch

1. Halbleiterbauelement für die Umsetzung von Licht in elektrische Energie mit mindestens einer Schicht amorphen Siliziums (3), an die sich auf der Lichteinfallseite des Halbleiterbauelements eine Deckschicht (4) aus polykristallinem Silizium anschliesst, wobei die Deckschicht (4) zwischen einer Antireflexschicht (2) aus halbleitendem transparentem Oxyd und der Schicht (3) aus amorphem Silizium angeordnet ist, und wobei die Deckschicht (4) die optische Dicke .

$$\frac{\lambda \text{ Licht}}{4} \text{ oder } \frac{3\lambda \text{ Licht}}{4}$$

aufweist und die Antireflexschicht (2) einen Brechungsindex $< 2{,}8$ besitzt.

## Claim

1. A semiconductor component for the conversion of light into electrical energy with at least one layer of amorphous silicon (3), adjacent to which on the light incidence side of the semiconductor component is a covering layer (4) of polycristalline silicon, in which respect the covering layer (4) is arranged between an anti-reflection layer (2) of semiconducting transparent oxide the layer (3) of amorphous silicon, and in which respect the covering layer (4) has the optical density

$$\frac{\lambda \text{ Light}}{4} \text{ or } \frac{3\lambda \text{ Light}}{4}$$

and the anti-reflection layer (2) possesses an index of refraction $< 2.8$.

## Revendication

1. Composant semi-conducteur pour la transformation de lumière en énergie électrique, comportant au moins une couche de silicium amorphe (3) à laquelle se rattache du côté d'incidence de la lumière dudit composant une couche de revêtement (4) en silicium polycristallin, dans lequel la couche de revêtement (4) est placée entre une couche antireflet (2) en oxyde transparent semi-conducteur et la couche (3) en silicium amorphe et dans lequel la couche de revêtement (4) présente l'épaisseur optique

$$\frac{\lambda \text{ lumière}}{4} \text{ ou } \frac{3\lambda \text{ lumière}}{4},$$

et la couche antireflet (2) un indice de réfraction inférieur à 2,8.

# FIG. 1

$\lambda = 5000$ Å

1

Glas

$n_G = 1.5$

2

ITO $(\lambda/4)$  $n_{ITO} \simeq 2$

a-Si  $n_{a\text{-}Si} = 5.3$

3

# FIG. 2

R  $\lambda = 5000$ Å

1

Glas  $n_G = 1.5$

2

ITO $(\lambda/4)$  $n_{ITO} \simeq 2$  4

poly-Si $(\lambda/4)$  $n_{x\text{-}Si} = 4.3$  (~290 Å)

a-Si  $n_{a\text{-}Si} = 5.3$

3